## Europäisches Patentamt
## European Patent Office
## Office européen des brevets

(11) Publication number: **0 163 460**
**A1**

# (12) EUROPEAN PATENT APPLICATION

(21) Application number: **85303479.1**

(22) Date of filing: **17.05.85**

(51) Int. Cl.⁴: **G 01 R 21/08**
**G 01 R 22/00**

(30) Priority: **18.05.84 GB 8412700**

(43) Date of publication of application:
**04.12.85 Bulletin 85/49**

(84) Designated Contracting States:
**CH DE FR GB IT LI NL SE**

(71) Applicant: **PILKINGTON BROTHERS P.L.C.**
**Prescot Road St. Helens**
**Merseyside, WA10 3TT(GB)**

(72) Inventor: **Butler, Kenneth J. National Westminster Bank**
**PLC**
**15 The Concourse Southway**
**Skelmersdale Lancashire WN8 6LD(GB)**

(72) Inventor: **Cross, Geoffrey**
**41 Queens Drive Newton-le-Willows**
**Merseyside WA12 OLY(GB)**

(74) Representative: **Haggart, John Pawson et al,**
**Page, White & Farrer 5 Plough Place New Fetter Lane**
**London EC4A 1HY(GB)**

(54) **A system for measuring the electrical consumption of a load.**

(57) The invention relates to a system for measuring the electrical energy consumed by a load. The system can be used in an energy meter or a wattmeter. The system employs a Hall effect element (23) with supply circuits (5, 18, 25), and switching means (9, 11) to control a relative phase change between the bias current and the magnetic field associated with the Hall effect element to cause thereby a change in the Hall output voltage which is fed to signal processing circuits (26, 27, 38, 47) and measuring circuits (48 to 51, 72, 85) to give a measure of the electrical energy consumed, which is independent of errors arising from the self-field effect of the bias current in the Hall effect element (23).

./...

EP 0 163 460 A1

Fig.1.

## A SYSTEM FOR MEASURING THE ELECTRICAL
## CONSUMPTION OF A LOAD

The present invention relates to a system for measuring the electrical energy consumed by a load and more particularly to a system employing a Hall effect element for use in an electrical energy measuring device, such as a domestic or commercial meter for measuring electric power consumption. Such a device could be a replacement for the conventional domestic electric meter recording energy consumption in kilowatt-hours.

Electrical energy measuring devices employing Hall effect elements are based on the principle that the Hall effect element produces a Hall output voltage proportional to the product of a bias current passing through the element and a magnetic field applied to the element. The magnitude of the bias current and the strength of the magnetic field are proportional to the load voltage and load current respectively. In such devices one of the problems is that the bias current itself produces a magnetic field which generates an error component in the Hall output voltage, referred to as the self-field effect error term. This error term can result in unacceptable inaccuracies of power measurement. The self-field effect error term is also temperature dependent in a non linear manner which makes correction methods difficult.

The d.c. component $V_0$ of the Hall output voltage of a Hall effect element connected as a power transducer is given by:-

$$V_0 = W + K_{sf} + E$$

where W is the true power, $K_{sf}$ is the self-field effect error term and E represents other errors independent of the phase angle between the load current and the load voltage, for example errors arising from thermo-electric effects.

The true power $W = K_h \times V_L \times I_L \times \cos p$

where $K_h$ is a gain constant

$V_L$ is the load voltage

$I_L$ is the load current p is the phase angle between $V_L$ and $I_L$

It is a main object of the invention to provide a measurement system which eliminates the self-field effect error term $K_{sf}$ and the other errors E, so that the Hall output voltage $V_0$ is an indication of the true power.

The true energy consumed over a period T is equal to $W \times T$ and the present invention provides a system for measuring that true energy, and which may be included in an electrical energy measuring device such as an energy meter or wattmeter.

According to the invention there is provided a system for measuring the electrical energy consumed by a load, including a Hall effect element, and supply circuits for the Hall effect element which are responsive to the load voltage and the load current and include a magnetic circuit for applying a magnetic field to the element and a bias current supply circuit, characterised in that the supply circuits include switching means operable to effect a relative phase shift between the bias current and the magnetic field at predetermined time intervals and thereby change the phase of a self field effect error component $K_{sf}$ of the Hall output voltage of the element, a processing circuit is connected to the output of the Hall effect element and is operable to generate in different time periods self-cancelling error signals derived from two different switched phases of the self field effect error component $K_{sf}$, and a measuring circuit is operable to receive the processed signals and to register a measurement proportional to the true power W and energy consumption of the load.

In a preferred embodiment the bias current supply circuit is operable to supply to the Hall effect element a bias current which is proportional to the load voltage, and the switching means is a phase shifting switch connected to control the input of a first operational amplifier which is thereby operable to shift the phase of the bias current relative to the magnetic field by 180°.

Preferably the first operational amplifier is connected to receive at its inverting input a voltage input proportional to the load voltage, and the switch is connected to the non-inverting input of the amplifier and is operable when closed to switch the voltage input to that non-inverting input, whereby the output of the amplifier is phase-shifted through 180°, and a voltage-to-current converter is connected between the output of the amplifier and the bias current input of the Hall effect element.

In the preferred embodiment the processing circuit includes an amplifier circuit connected to the output of the Hall effect element and whose output is connected through a zero switch to a second operational amplifier which is connected to receive the amplified Hall output voltage at its inverting input, and the switching means includes a phase-shifting switch operable when closed in synchronism with the switch to switch the amplified Hall output voltage to the non-inverting input of the amplifier, whereby the output from the second operational amplifier is a voltage having a component which is proportional to the true power W and the sign of which is independent of the state of the switches and an error component due to the Hall effect element the converter, the amplifier circuit and the amplifier whose sign is dependent on the state of the switch.

The amplifier circuit may include a low pass filter to attenuate alternating components of the Hall output voltage.

For measuring the electrical energy consumed by a load connected to a polyphase supply, the system may include for each phase a Hall effect element with its supply circuits, and a differential amplifier connected to the output of the Hall effect element, and wherein the outputs of the differential amplifiers representative of the apparent load power consumed at the respective phases are connected to inputs of a summing amplifier whose output is connected through a zero switch to a second operational amplifier which is connected to receive the amplified summed Hall output voltages at its inverting input, and the switching means includes a phase-shifting switch operable when closed in synchronism with the switch in each phase to switch the summed Hall output voltage to the non-inverting input of the amplifier, whereby the output of the amplifier is a voltage having a component which is proportional to the true polyphase power W and the sign of which is independent of the state of the switches and an error component due to the Hall effect elements, the differential amplifiers, and the amplifier whose sign is dependent on the state of the switch.

Further according to the invention the processing circuit may include a voltage-to-frequency converter which is connected to the output from the second operational amplifier and is operable to generate a digital pulse train representative of the output voltage from the amplifier.

Still further according to the invention the measuring circuit includes a totaliser counter connected to the output of a two-position switch having inputs connected to the output of the voltage-to-frequency converter and to a clock pulse timing circuit, and logic elements controlled by the timing circuit and operable at predetermined times to control the phase-shifting switching the zero switch and the counter, so that the counter receives digital signals indicative of the true load power W and two different switches phases of the self-field effect error component $K_{sf}$ which are self-cancelling in the counter.

In the preferred embodiment the measuring circuit includes an error counter which is connected to the output of the two-position switch and is operable in a first time period when the zero switch is closed and the totaliser counter is inhibited by the logic circuit to accumulate a number corresponding to the zero errors of the second operational amplifier and the voltage-to-frequency converter, and is operable through the switch in another time period to receive timing pulses from the timing circuit which count the counter to zero while master clock pulses are received by the totaliser counter to subtract from the counter a number representative of the zero errors of the second operational amplifier and the converter.

The system may include a display connected to the totaliser counter to display an indication of energy consumption accumulated by the totaliser counter.

The invention also provides a system according to the invention in a domestic power consumption meter wherein the display gives a direct accumulative visual read-out of energy consumption.

Some embodiments of the invention will now be described, by way of example, with reference to the accompanying drawings, in which:-

Figure 1 is a circuit diagram of an analogue stage of one embodiment of an energy measuring system according to the present invention,

Figure 2 is a circuit diagram of a digital stage of the energy measuring system of Figure 1,

Figure 3 is a timing diagram illustrating the relative states of various parameters of the energy measuring system of Figures 1 and 2 during operation,

Figure 4 is a circuit diagram of a second embodiment of an energy measuring system according to the invention,

Figure 5 is a circuit diagram of a third embodiment of an energy measuring system according to the invention,

Figure 6 is a circuit diagram of a fourth embodiment of an energy measuring system according to the invention, and

Figure 7 is a circuit diagram of a fifth embodiment of an energy measuring system of the invention.

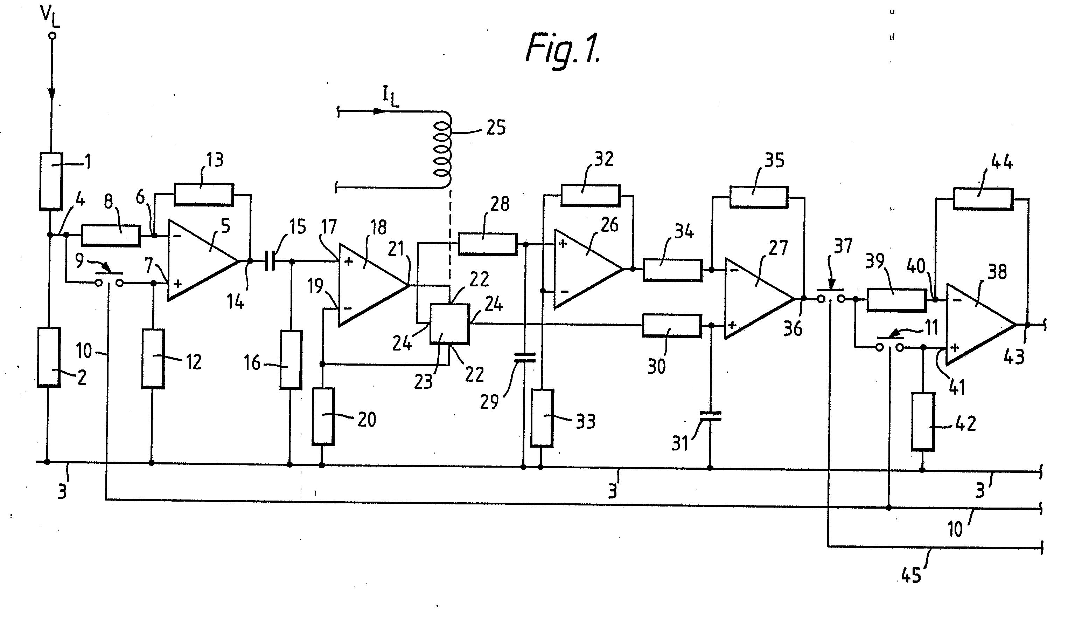

Referring to Figure 1 a system for measuring the electrical energy consumed by a load includes a voltage divider consisting of two resistors 1 and 2 which in operation are for connection across a load voltage $V_L$ which is being applied to a load, the energy consumption of which is to be measured. A circuit common line 3 is connected to a neutral supply terminal. The values of resistors 1 and 2 are chosen to reduce the voltage on a line 4 between resistors 1 and 2 to about 1 volt. This reduced voltage is used to drive an operational amplifier 5, the inverting input 6 and non-inverting input 7 of which are respectively connected to the line 4 via a resistor 8 and a phase-shifting switch 9. The switch 9 is a solid state device and is shown diagramatically in its open state and its condition is controlled by a phase-shift signal transmitted on line 10, which signal also controls a second phase-shifting switch 11 which is also a solid state device. The non-inverting input 7 of the operational amplifier 5 is connected to the common line 3 via a resistor 12.

A feedback resistor 13 is connected from the output 14 of the amplifier 5 to its inverting input 6. When the switch 9 is closed the voltage at the output 14 is in phase with the input voltage. When the switch 9 is open the voltage at the output 14 is inverted, which is an effective phase shift of 180°. The resistors 8 and 13 are matched so that the magnitude of the output voltage from the amplifier 5 is constant irrespective of its phase as determined by the condition of the switch 9.

The output 14 is coupled by a coupling capacitor 15 and resistor 16 to the non-inverting input 17 of a voltage-to-current converter 18 which also has an inverting input 19 which is connected to the common line 3 by a resistor 20. Any d.c. voltage component of the output signal from the amplifier 5 is blocked by the capacitor 15.

The output 21 from the converter 18 is connected to a bias current input terminal 22 of a Hall effect element 23. The other bias current input terminal 22 of the element 23 is connected to the inverting input 19 of the converter 18. An A.C. bias current which is proportional to the load voltage $V_L$ is thus supplied to the Hall effect element 23.

When the switch 9 is closed the A.C. bias current is in phase with the load voltage $V_L$. When the switch 9 is open the A.C. bias current is phase shifted by $180^0$ with respect to the load voltage $V_L$.

The Hall output voltage $V_0$ of the Hall effect element 23 appears across the output terminals 24.

The load current $I_L$ flowing in the load whose energy consumption is being measured, or a current proportional to that load current $I_L$, flows through a coil 25 of a magnetic circuit containing the Hall effect element 23. The strength of the magnetic field applied to the element 23 is proportional to the load current $I_L$. The Hall output voltage $V_0$ across output terminals 24 has a d.c. component which is proportional to the power W consumed by the load. Because the bias current supplied to terminals 22 is an A.C. current, the self-field effect error term $K_{sf}$ is represented in the output voltage as an A.C. component of that voltage, the phase of which component with respect to the load voltage $V_L$ depends on the position of the switch 9.

The Hall output voltage $V_0$ is amplified by two operational amplifiers 26 and 27 which are connected in differential mode. One output terminal 24 is coupled to the non-inverting input of amplifier 26 by a low-pass filter consisting of resistor 28 and capacitor 29. The other
output terminal 24 is coupled by a second low-pass filter consisting of
resistor 30 and capacitor 31 to the non-inverting input of amplifier
27. A feedback resistor chain 32, 33 is connected between the output
of amplifier 26 and the line 3, and its mid-point is connected to the
inverting input of the amplifier 26 whose output is connected by
resistor 34 to the inverting input of amplifier 27. A feedback
resistor 35 is connected between the output 36 of the amplifier 27 and
its inverting input.

The two low-pass filters 28, 29 and 30, 31 attenuate any alternating
component in the Hall output voltage, in particular they attenuate the
self-field effect error terms of the output voltage.

The output signal at the output 36 of the operational amplifier 27 is a
DC signal having a component which is proportional to the true load
power W and the sign of which component depends upon the position of
the switch 9. Additional components of the DC output signal at 36 are
a component proportional to the error terms ($K_{SF}$ + E) arising in the
Hall effect element 23 and a component proportional to any zero errors
in the amplifiers 26 and 27. The sign of these additional components
are independent of the condition of the switch 9.

The output 36 of the amplifier 27 is coupled by a zero switch 37 to a
further operational amplifier 38 which provides a first processing
stage for the output signal from the amplifier 27. The switch 37 is
also a solid state device and is indicated diagramatically in open
condition. The switch 37 is connected through a resistor 39 to the
inverting input 40 of the amplifier 38, and is connected through the
phase-shifting switch 11 to the non-inverting input 41 of the amplifier
38. A resistor 42 connects the non-inverting input 41 to the common
line 3, and the output 43 from the amplifier 38 is connected by a
feedback resistor 44 to the inverting input 40.

The output signal from the amplifier 27 is only transmitted to the amplifier 38 when the zero switch 37 is closed. The switch 37 is controlled by a level on a control line 45. A low level on the line 45 maintains the switch 37 open, which breaks the forward feed of the measurement signal to the amplifier 38.

The amplifier 38 operates as a phase-shifting inverter in the same manner as the amplifier 5. When the zero switch 37 is closed and the switch 11 is operated in synchronism with the switch 9, the change in sign in the amplifier 38 of the signal component which is proportional to the true power W compensates for any sign change produced by the amplifier 5. The sign of the true power signal component W on line 43 is thus independent of the condition of the phase-shifting switches 9 and 11. The sign of the additional error components of the signal at the output 36 is changed by the amplifier 38 when the phase-shifting switch 11 changes state, so that the sign of the error signal components of the signal on line 43 is dependent on the state of the phase-shifting switch 11.

When the switch 9 changes state the time constants of the filters 28, 29 and 30, 31 create a delay such that the output of amplifier 27 does not change instantaneously. During this time delay the zero switch 37 is maintained open until the output of amplifier 27 is stable.

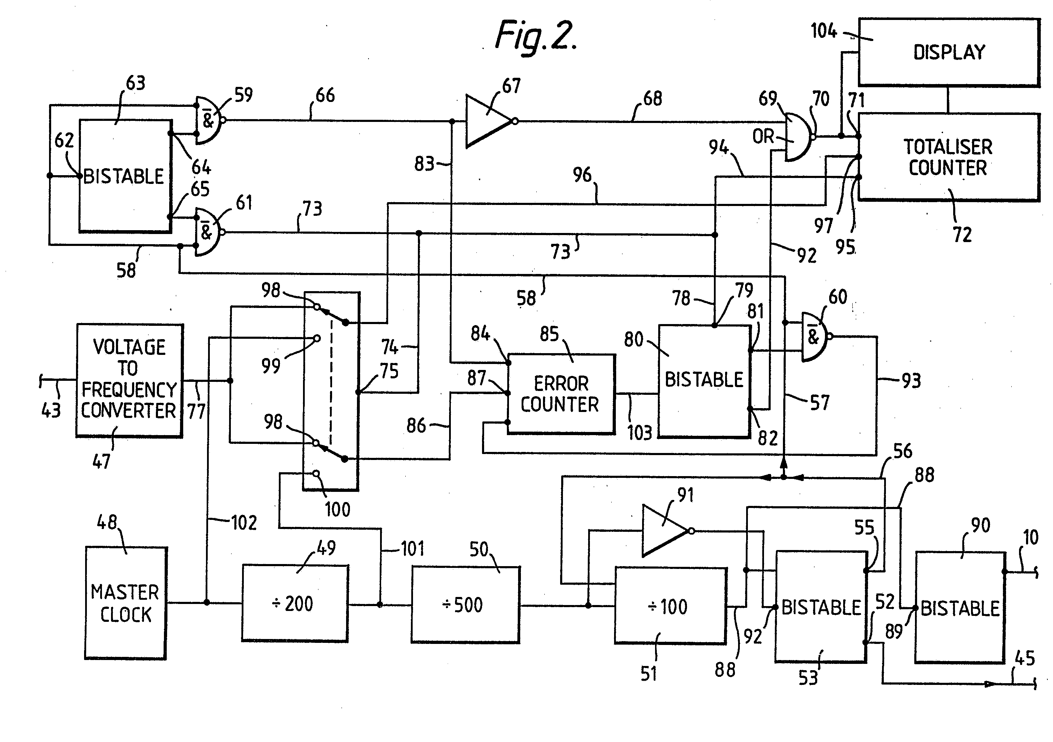

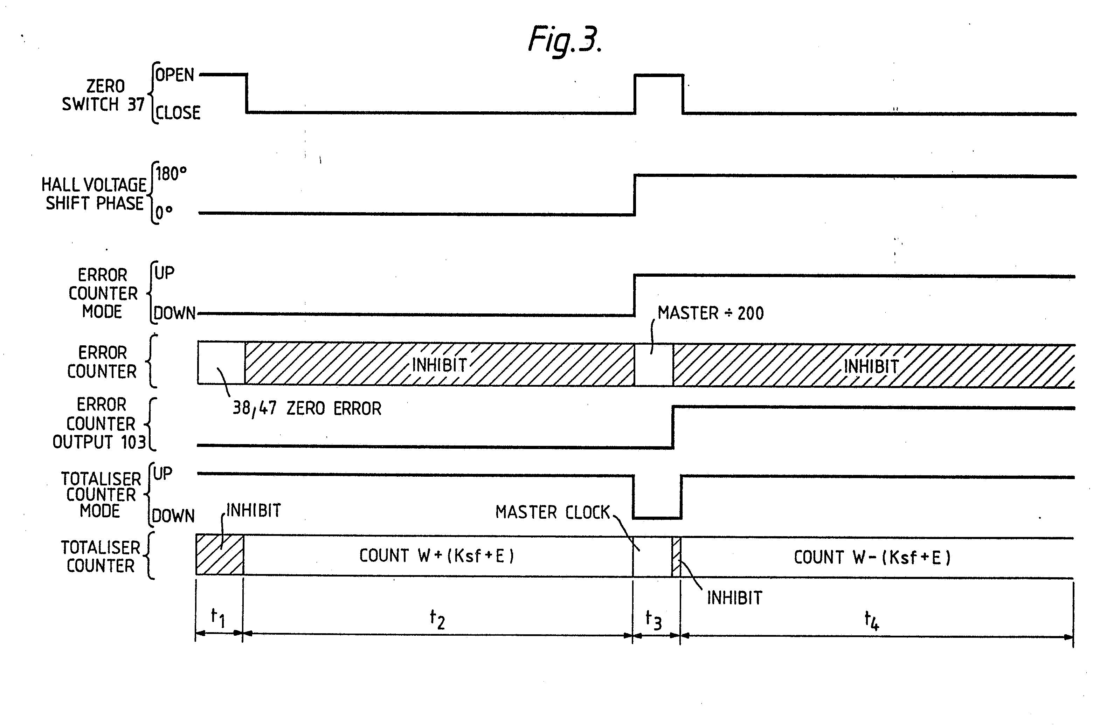

The output line 43 is connected to a voltage-to-frequency converter 47, Figure 2, which converts the output signal from the amplifier 38 to a digital pulse train for further processing. The frequency of the pulse train output from the voltage-to-frequency converter 47 is dependent on its input voltage which in turn (ignoring the error signals) is the instantaneous value of the wattage as measured by the Hall effect device. In order to obtain a measurement of the rate at which energy is consumed in the load, the output signal from the amplifier 38 is integrated with respect to time by counting the pulse train output from the converter 47 in a measurement period by a totaliser counter which integrates the wattage to accumulate a value which is displayed in an appropriate display directly in kilowatt-hours, or as the total energy consumption on any other desired scale. This will now be described with reference to Figures 2 and 3.

The measurement period is split into four parts $t_1$ to $t_4$, Figure 3, where $t_1 = t_3$, $t_2 = t_4$ and $t_2 = t_1 \times M$ where M is 100. Typically $t_1$ may be set at 4 seconds duration; $t_2$ is therefore of 400 seconds duration.

The components of the processing circuit of Figure 2 may also have zero errors which would affect the accumulated measurement, and in period $t_1$ a number equivalent to any such zero errors in the amplifier 38 and the converter 47 is accumulated in an error counter. This is done with the zero switch 37 open.

All the timing is derived from a master clock oscillator 48 whose output is divided down by dividers 49, 50 and 51 by factors of 200, 500 and 100 respectively. The oscillator 48 and the dividers 49, 50 and 51 serve to operate the logic circuits of Figure 2 to provide the required sequence of operation of the phase shifting switches 9 and 11 and the zero switch 37 in Figure 1.

The level on control line 45 for the zero switch 37 is derived from a terminal 52 of a bistable 53 during the period $t_1$ the output at the terminal 52 is low (i.e. 0) and this low output is transmitted on the line 45 to maintain the zero switch 37 of Figure 1 in its open state, as indicated in Figure 3.

During the period $t_1$ the phase-shifting switches 9 and 11 are open, and because the zero switch 37 is also open there is no signal input to the amplifier 38. Also during the period $t_1$ the output at a terminal 55 of the bistable 53 is high (i.e. 1) and this high output is fed via lines 56, 57 and 58 to one input of each of the NAND gates 59, 60 and 61, and to the input 62 of a bistable 63 whose output terminals 64 and 65 are at 1 and 0 respectively and are respectively connected to input of the NAND gates 59 and 61. The NAND gate 59 therefore transmits a 0 output on a line 66 to an inverter 67. The inverter 67 transmits a 1 output along a line 68 to an OR gate 69 whose output 70 is connected to an inhibit input 71 of a totaliser counter 72 whose function is to register, at the end of the measurement period, a count indicative of the average wattage over that period. The OR gate 69 generates a 1 output which inhibits the totaliser counter 72.

A 1 output signal is transmitted from the NAND gate 61 on lines 73 and 74 to an input 75 of an analogue switch 76 to maintain its connections to a line 77 which is connected to the output of the voltage-to-frequency converter 47. The line 77 carries the digital pulse train generated by the converter and that pulse train is selectively switched, as will be described, to the totaliser counter and to the error counter. The output signal from the NAND gate 61 is also transmitted along lines 73 and 78 to an input 79 of a bistable 80 to generate 1 and 0 outputs on terminals 81 and 82 respectively.

During the period $t_1$ the 0 output from the NAND gate 59 on the line 66 is fed on a line 83 to an input 84 of the error counter 85 to produce a down mode in the error counter 85, as indicated in Figure 3. As there is a 0 output from the NAND gate 60 the error counter 85 is not inhibited and is counted down by the output of the voltage-to-frequency converter 47 which is fed to the counter 85 via the line 77, the analogue switch 76 and a line 86 which is connected to the input 87 of the error counter 85. Because the zero switch 37 is open during the period $t_1$, the output of converter 47 is due only to its own zero error and any zero error of amplifier 38 (Figure 1). During the period $t_1$ the output signal of converter 47 typically has a frequency of very approximately 100Hz. By the end of the period $t_1$ the error counter has been counted down by a number indicative of the zero errors of the amplifier 38 and the converter 47.

The 1 output on terminal 55 of the bistable 53 also serves to reset the divider 51 whose output is fed on a line 88 to the input 89 of a bistable 90 whose output signal is the phase-shift signal which is fed on line 10 to control in synchronism the states of the phase-shifting switches 9 and 11.

At the end of period $t_1$ a 0 output from divider 50 is converted by an inverter 91 to a 1 input signal for the input 92 of bistable 53. This flips bistable 53 so that during the period $t_2$ there is a 1 output at terminal 52 of the bistable 53 which, on line 45, maintains the zero switch 37 in its closed state. The phase-shifting switches 9 and 11 are both still open and the phase difference between the bias current and the magnetic field on the Hall element 24 is p. Also during the period $t_2$ there is a 0 output at terminal 55 of the bistable 53 which is fed via lines 56, 57 and 58 to one input of each of the NAND gates 59, 60 and 61. The NAND gate 59 now produces a 1 output on line 66 which the inverter 67 changes to a 0 output on line 68 which is applied to one input of the OR gate 69. The output on a line 92 from the output terminal 82 of the bistable 80 is fed to the other input of the OR gate 69, which output is still 0, thus the output of the OR gate 69 is 0 and the totaliser counter 72 is no longer inhibited.

The output from the terminal 81 of bistable 80 is still 1, and is transmitted to the other input of the NAND gate 60, the first input of the NAND gate 60 being maintained at 0 on the line 57. The NAND gate 60 therefore transmits a 1 output along a line 93 which is connected to an inhibit input of the error counter 85, causing the error counter 85 to be inhibited. The output of the NAND gate 61 is still 1 which output is fed on the lines 73 and 94 to an input 95 of the totaliser counter 72 to keep the totaliser counter 72 in its up counting mode. Hence the output of the voltage-to-frequency converter 47, is fed via the line 77, the analogue switch 76 and by a line 96 to an input 97 of the totaliser counter 72 and is counted up by the counter 72. During the period $t_2$ the output signal of the converter 47 typically has a frequency within the range 100 Hz to 25 KHz. Because the zero switch 37 is closed, by the end of the period $t_2$ the count registered in the totaliser counter 72 is proportional to the true load power W plus one phase of the error terms ($K_{sf}$ + E) and the zero errors of the amplifiers 26 and 27, and any error term of the amplifier 38 and the voltage-to-frequency converter 47.

At the end of the period $t_2$ the bistable 53 is again flipped so that during the period $t_3$ the output 52 of the bistable 53 is back to 0 to open the zero switch 37. At the end of the period $t_2$ the divider 51 generates a pulse along the line 88 which flips the bistable 90 causing a pulse to be generated along the line 10 to switch the switches 9 and 11 into their closed state, so that the bias current in the Hall effect element 23 is 180° out-of-phase with the magnetic field.

The output at terminal 55 of the bistable 53 is now a 1 output which is fed via the lines 56, 57 and 58 to one input of each of the NAND gates 59, 60 and 61. The output at the terminal 64 of bistable 63 is flipped to 0 by the 1 input on line 58 so the resulting output on line 66 is 1. There is therefore a 0 output on the line 68 to the OR gate 69. As the output 81 of bistable 80 is still 0, the output of the OR gate 69 is 0 and the totaliser counter 72 remains not inhibited.

The 1 output on the line 66 is fed via the line 83 to set the error counter 85 in its up counting mode. As the inputs at NAND gate 61 are both 1 so the output along the line 73 is 0. This 0 output on the line 73 is fed along the line 74 to the analogue switch 76 to switch the electrical connection from terminals 98 which are connected to line 77 to the input terminals 99 and 100 which are respectively connected by a line 101 to the output of the ÷ 200 divider 49, and by a line 102 to the output of the master clock oscillator 48.

The 0 output on the line 73 is also fed along line 78 to reset the bistable 80, and on line 94 to set the totaliser counter 72 in its down counting mode, as indicated in Figure 3.

During the period $t_3$, as indicated in Figure 3, therefore the error counter 85 is counted up to zero by pulses from the divider 49 at the master clock rate divided by 200, the pulses being transmitted by the line 101 to terminal 100 of switch 76 and then on line 86 to the input 87 of the error counter 85. The totaliser counter 72 is counted down at the master clock rate by master clock pulses on line 102 connected to terminal 99 of switch 76, which pulses are switched on to line 96 which is connected to the clock pulse input 97 of the counter 72. At a time before the end of the period $t_3$ when the error counter 85 has counted up to zero, it transmits an output signal on a line 103 to the bistable 80 which flips the output on terminal 81 to 0 and the output on terminal 82 to 1. The 1 output on line 92 causes the OR gate 69 output to inhibit the totaliser counter 72.

This inhibit of the totaliser counter 12 is maintained for a period immediately prior to the start of the period $t_4$. The period of the inhibit, which begins when the error counter has counted up to zero, is therefore dependent on the time it has taken for the error counter 85 to count to zero. Typically this time can be less than one second and the period of the inhibit typically more than 3 seconds but less than 4 seconds. At the beginning of the inhibit the totaliser counter 72 will have been counted down by an amount equal to the zero error measured during the period $t_1$ multiplied by 200, i.e. the total zero error that the error measured during $t_1$ will produce over the measuring periods $t_2$ and $t_4$.

At the start of the period $t_4$ the switches 9 and 11 are still closed, and the phase difference between the bias current and the magnetic field of the Hall element 24 is maintained at $(p + 180^o)$. The output at the terminal 52 of bistable 53 has flipped back to 1 to close the zero switch 37 and the output at terminal 55 of bistable 53 is 0.

During the period $t_4$ therefore the phase shift of the bias current relative to the magnetic field is $180^o$ and the totaliser counter 72 again counts up the output of converter 47, but this time at a rate proportional to the true load power W plus zero errors from amplifier 38 and converter 47 minus the other phase of the error terms ($K_{sf}$ + E) and the zero errors of amplifiers 26 and 27.

At the end of period $t_4$ the count in totaliser counter 72 is a measurement proportional to the true average energy over the period $t_2$ + $t_4$. This is because the zero errors arising from amplifier 38 and converter 47 during the combined periods $t_2$ and $t_4$ have been compensated for in the counter 72 during the period $t_3$ under control of the error counter 85, and the error terms ($K_{SF}$ + E) and the zero errors arising from the amplifiers 26 and 27 have the same absolute magnitude during periods $t_2$ and $t_4$ but change phase and sign and are therefore self-cancelling.

The device thus operates as a wattmeter and the true average rate of consumption of energy over period $t_2$ + $t_4$ in each measurement period is displayed on a display 104 which is connected by a line 105 to the output 70 of the OR gate 69, and/or is used for tariff calculations. The average power over the period $t_2$ + $t_4$ can be calculated by dividing the measurement in totaliser counter 72 by the time $t_2$ + $t_4$. The above sequence of operations is then repeated.

If an average is to be taken over several measurement periods an accumulation in the totaliser counter is effected, followed by division, and timing control circuits can be included to activate suitable circuits for carrying out those functions. The system can thus be used in commercial power installations where readings of both instantaneous wattage and accumulated power consumption in kilowatt-hours are required.

In the embodiment just described the integration with respect to time of the Hall output voltages is accomplished by digital processing, it is possible to carry out the integration by analogue processing techniques.

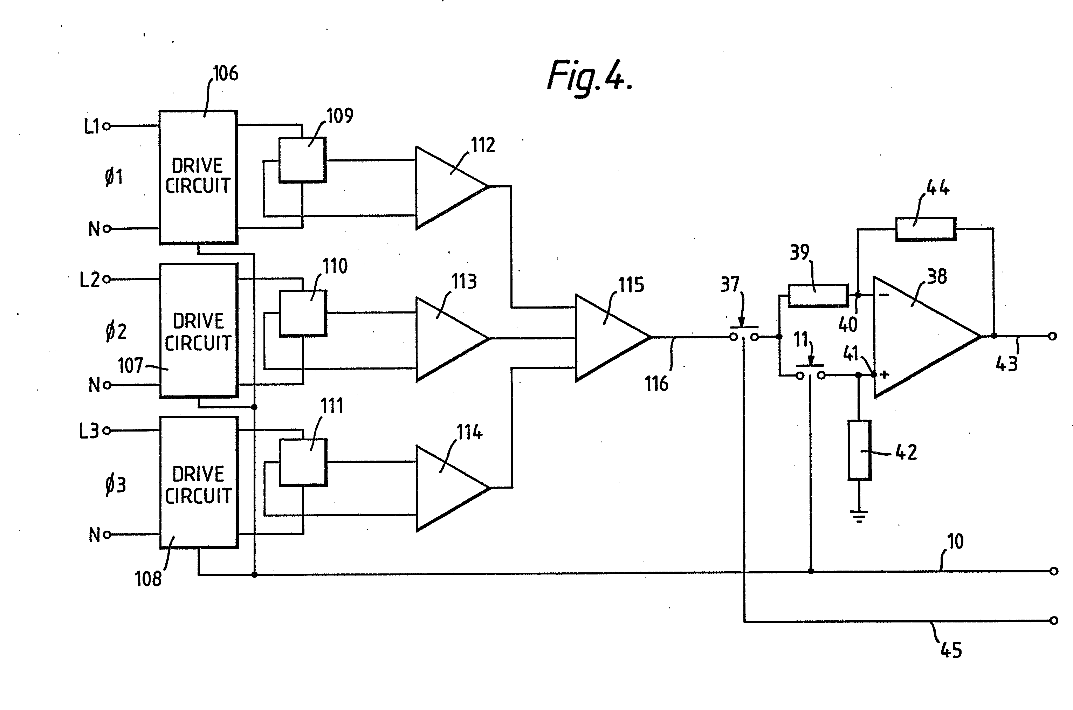

The circuits described with reference to Figures 1 and 2 can be applied to polyphase power or energy measurements. In such cases the circuit of Figure 1 is repeated for each phase. A typical circuit arrangement for measuring the energy consumed by a three phase load L1, L2, L3 is illustrated in Figure 4.

Three drive circuits 106, 107 and 108 are each connected to respective Hall elements 109, 110, and 111. Each of the drive circuits comprises an operational amplifier 5 and voltage-to-current converter 18, and associated circuits as illustrated in Figure 1. Each of the Hall elements 109, 110, and 111 is connected to a differential amplifier output stage respectively 112, 113 and 114 which are each representative of the circuits in Figure 1 between the Hall element 23 and the switch 37. The output of each of the amplifier stages 112, 113 and 114 is a d.c. signal proportional to the apparent load power consumed at the respective phase, and the three outputs are fed to the input of a summing amplifier 115 whose output signal on line 116 is the sum of the apparent load power consumed by the three phases. The output signal on line 116 is processed in an identical manner to that described with reference to Figures 1 and 2 above.

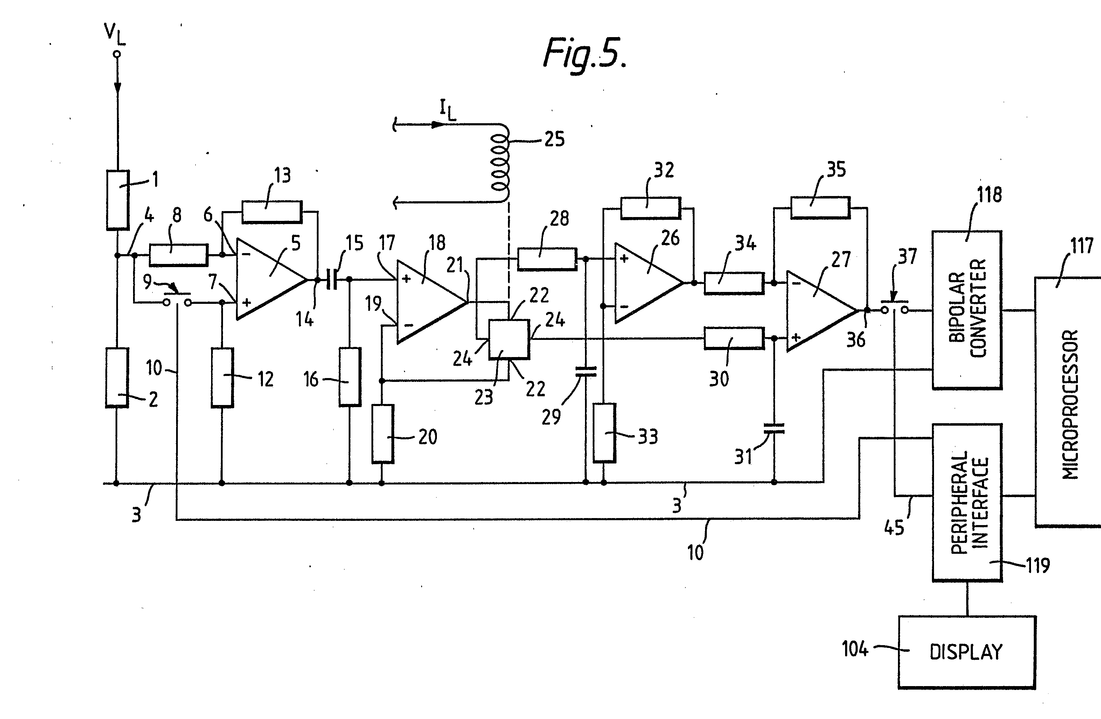

Another circuit arrangement of a single phase energy measuring system is illustrated in Figure 5 which circuit is the same as that of Figure 1 up to the zero switch 37. The output from amplifier 27 is fed to a microprocessor 117 which effects the timing, switching, counting and other logic functions carried out by the circuit of Figure 2. The voltage to frequency converter 47 of Figure 2 is replaced in Figure 5 by a bipolar analogue to digital converter 118 and a peripheral interface 119 is provided to transmit the signals to control the switches 11 and 37 and to transmit measurements to the display 104.

In addition the microprocessor 117 may carry out logic functions to provide both instantaneous wattage and accumulated power consumption readings.

The switches 9, 11 and 37 in the embodiments just described are in the form of solid state analogue switches; they can be electro-mechanical switches.

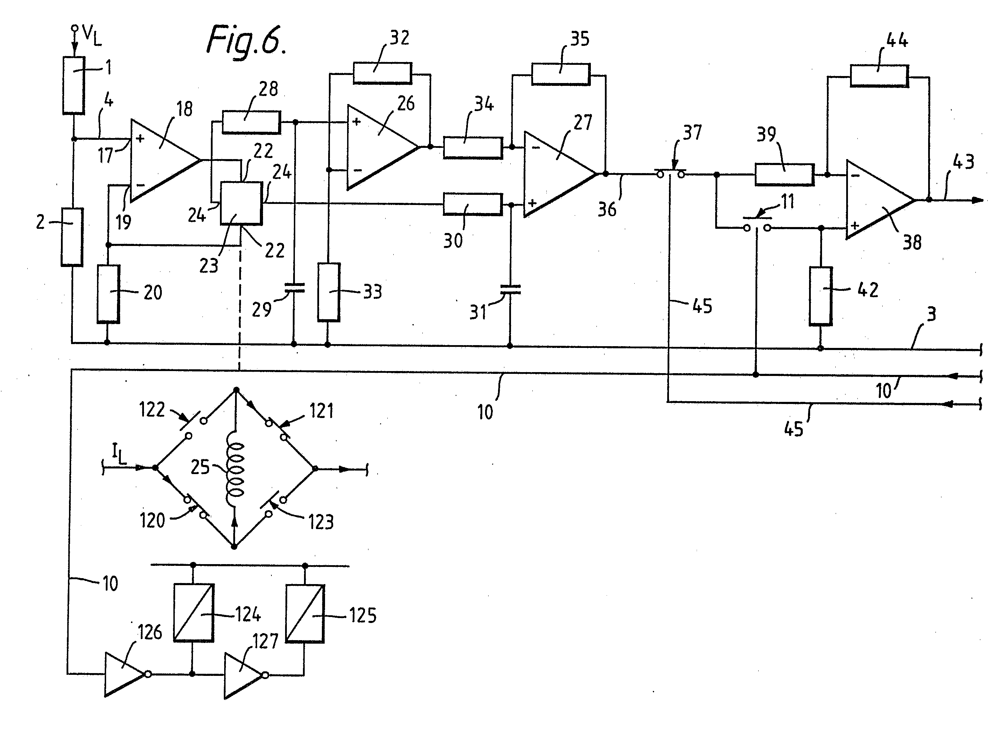

Figure 6 illustrates a modification of the circuit of Figure 1 in which the phase shift of 180° between the bias current and the magnetic field is effected by keeping the phase of the bias current constant whilst changing the phase of the magnetic field.

In Figure 6 the load current $I_L$ is fed to an arrangement of four relay switches 120, 121, 122 and 123 in a bridge circuit spanned by the coil 25.. The pair of relays 120 and 121 are closed simultaneously in response to energisation of a solenoid 124, and the pair of relays 122 and 123 are closed simultaneously in response to energisation of a solenoid 125. The sequential energisation of the solenoid 124 and the solenoid 125 is controlled by control signals on the line 10 via a pair of inverters 126 and 127. When the solenoid 124 is energised the load current passes via relay 120, the coil 25 and the relay 121 as indicated by the arrows. The energisation of solenoid 124 occurs during the period $t_1$ and $t_2$ shown in the timing diagram of Figure 3.

During the periods $t_3$ and $t_4$ the solenoid 125 is energised and the solenoid 124 de-energised causing the current to pass via the relay 122, the coil 25 and the relay 123. As the current is now passing in the opposite direction through the coil 25 there is a change in the phase of the magnetic field by 180° resulting in a phase change between the bias current and magnetic field of 180°. Whereas the relays have been described as electro-magnetic in operation they could alternatively take solid state form.

It will be appreciated that the phases of the bias current and magnetic field can be changed simultaneously each by different amounts so as to create a relative phase shift of 180°.

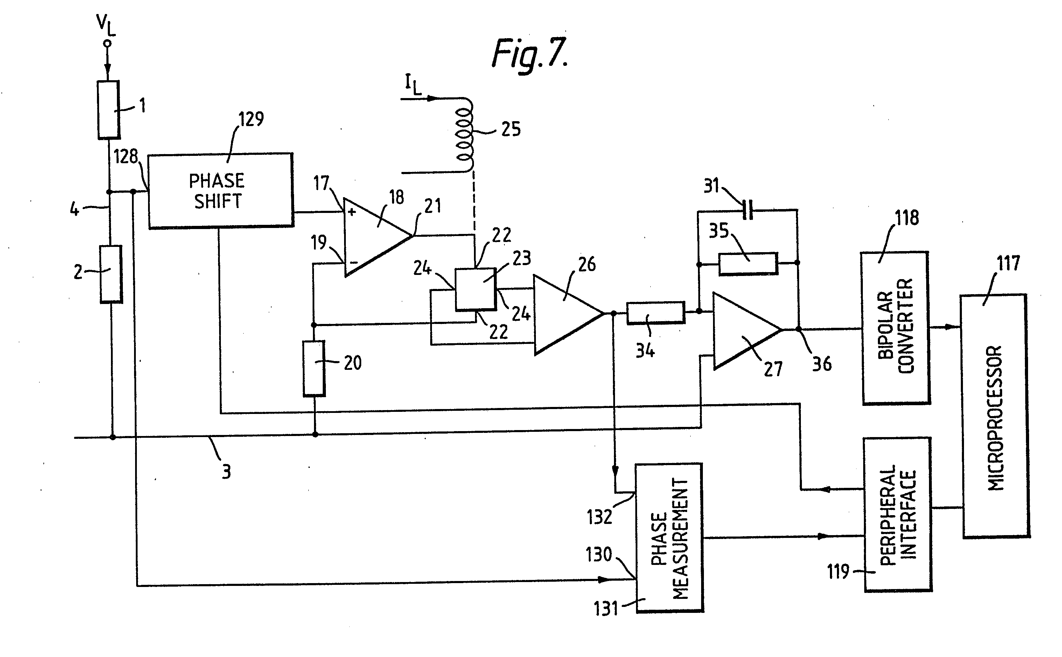

Figure 7 illustrates a further embodiment of the invention having features similar to the embodiment of Figure 5. The reduced voltage on the line 4 is fed directly to an input 128 of a phase shifting circuit 129 and to an input 130 of a phase measurement circuit 131. The phase shifting circuit 129 is controlled by the timing circuit in the microprocessor 117 to give a zero phase shift to the incoming reduced voltage signal during a first period. During this period the output from the operational amplifier 26 consists of a DC signal whose magnitude is proportional to the magnitude of the Hall output voltage, and an AC signal whose phase is a function of the phase between the load voltage and the load current.

The AC and DC signals from amplifier 26 are transmitted to the operational amplifier 27 which amplifies the DC signal, the AC signal being attenuated by the low pass filter consisting of resistor 35 and capacitor 31. The amplified DC signal is then transmitted to the bipolar analogue to digital convertor 118 the output of which is monitored by the microprocessor 117 to give a measure of the apparent energy consumed by the load over the first period.

The AC signal from amplifier 26 is also transmitted to a second input 132 of the phase measurement circuit 131 where the phase angle between the load voltage and the load current is determined. The phase measurement circuit 131 transmits this information via the peripheral interface 119 to the microprocessor 117 which calculates the phase shift necessary to make the phase angle between the load voltage and the load current equal to 90°. At a suitable time the microprocessor signals the phase shifting circuit 129 to make that calculated phase shift to the incoming reduced voltage on the line 4 thus resulting in the creation of a 90° phase angle between the bias current and the magnetic field of the Hall effect element 23. The measured true load power is now effectively zero since Cos p is now zero. The microprocessor 117 therefore measures only errors in the circuitry and contributions to the Hall voltage from error terms $(K_{SF} + E)$. The microprocessor 117 measures these errors over a second period, calculates the accumulated error over the first period and then subtracts the calculated accumulated error measurement over the first period from the measurement of the apparent energy consumed over the first period to give a true energy measurement of the power consumed over the first period.  This sequence is then repeated at suitable intervals.

Any of the systems described above can be incorporated as part of an energy meter for measuring the electrical energy consumed by a load. In addition any of the systems can be incorporated in a wattmeter, means being provided for dividing the measurement of the energy consumed by the load over a preset period by that period to give a measure of the average power consumption of the load over that period.

In the embodiments described above the bias current is dependent on the load voltage, and the strength of the magnetic field is dependent on the load current.  It would be possible to provide systems according to the invention by the inclusion of shunts or transformers, so as to have the bias current dependent on the load current and the strength of the magnetic field dependent on the load voltage.

Claims:

1.    A system for measuring the electrical energy consumed by a load, including a Hall effect element (23), and supply circuits for the Hall effect element which are responsive to the load voltage and the load current and include a magnetic circuit (25) for applying a magnetic field to the element (23) and a bias current supply circuit (5, 18), characterised in that the supply circuits include switching means (9) operable to effect a relative phase shift between the bias current and the magnetic field at predetermined time intervals and thereby change the phase of a self field effect error component ($K_{sf}$) of the Hall output voltage of the element (23), a processing circuit (26, 27, 38, 47) is connected to the output (24) of the Hall effect element (23) and is operable to generate in different time periods self-cancelling error signals derived from two different switched phases of the self field effect error component ($K_{sf}$), and a measuring circuit (48 to 51, 72, 85) is operable to receive the processed signals and to register a measurement proportional to the true power (W) and energy consumption of the load.

2.    A system as claimed in Claim 1, wherein the bias current supply circuit (5, 18) is operable to supply to the Hall effect element (23) a bias current which is proportional to the load voltage, and the switching means is a phase shifting switch (9) connected to control the input of a first operational amplifier (5) which is thereby operable to shift the phase of the bias current relative to the magnetic field by 180°.

3.    A system as claimed in Claim 2, wherein the first operational amplifier (5) is connected to receive at its inverting input (6) a voltage input proportional to the load voltage, and the switch (9) is connected to the non-inverting input (7) of the amplifier and is operable when closed to switch the voltage input to that non-inverting input, whereby the output of the amplifier is phase-shifted through 180°, and a voltage-to-current converter (18) is connected between the output of the amplifier (5) and the bias current input (22) of the Hall effect element (23).

4.    A system as claimed in Claim 3, wherein the processing circuit includes an amplifier circuit (26, 27) connected to the output (24) of the Hall effect element (23) and whose output (36) is connected through a zero switch (37) to a second operational amplifier (38) which is connected to receive the amplified Hall output voltage at its inverting input, and the switching means includes a phase-shifting switch (11) operable when closed in synchronism with the switch (9) to switch the amplified Hall output voltage to the non-inverting input of the amplifier (38), whereby the output from the second operational amplifier (38) is a voltage having a component which is proportional to the true power (W) and the sign of which is independent of the state of the switches (9, 11) and an error component due to the Hall effect element (23), the converter (18), the amplifier circuit (26, 27) and the amplifier (38) whose sign is dependent on the state of the switch (11).

5.    A system as claimed in Claim 4, wherein the amplifier circuit (26, 27) includes a low pass filter (28, 29; 30, 31) to attenuate alternating components of the Hall output voltage.

6.    A system as claimed in Claim 3, for measuring the electrical energy consumed by a load connected to a polyphase supply, including for each phase a Hall effect element (109, 110, 111) with its supply circuits, and a differential amplifier (112, 113, 114) connected to the output of the Hall effect element, and wherein the outputs of the differential amplifiers representative of the apparent load power consumed at the respective phases are connected to inputs of a summing amplifier (115) whose output is connected through a zero switch (37) to a second operational amplifier (38) which is connected to receive the amplified summed Hall output voltages at its inverting input, and the switching means includes a phase-shifting switch (11) operable when closed in synchronism with the switch (9) in each phase to switch the summed Hall output voltage to the non-inverting input of the amplifier (38), whereby the output of the amplifier (38) is a voltage having a component which is proportional to the true polyphase power (W) and the sign of which is independent of the state of the switches (9, 11) and an error component due to the Hall effect elements (109, 110, 111), the differential amplifiers (112, 113, 114), and the amplifier (38) whose sign is dependent on the state of the switch (11).

7.     A system as claimed in any one of Claims 4 to 6, wherein the processing circuit includes a voltage-to-frequency converter (47) which is connected to the output from the second operational amplifier (38) and is operable to generate a digital pulse train representative of the output voltage from the amplifier (38).

8.     A system as claimed in Claim 7, wherein the measuring circuit includes a totaliser counter (72) connected to the output of a two-position switch (76) having inputs connected to the output of the voltage-to-frequency converter (47) and to a clock pulse timing circuit (48 to 51), and logic elements (53, 63, 80, 90) controlled by the timing circuit and operable at predetermined times to control the phase-shifting switches (9, 11), the zero switch (37) and the counter (72), so that the counter (72) receives digital signals indicative of the true load power (W) and two different switched phases of the self-field effect error component $(K_{sf})$ which are self-cancelling in the counter (72).

9.     A system as claimed in Claim 8, wherein the measuring circuit includes an error counter (85) which is connected to the output of the two-position switch (76) and is operable in a first time period $(t_1)$ when the zero switch (37) is closed and the totaliser counter (72) is inhibited by the logic circuit (63) to accumulate a number corresponding to the zero errors of the second operational amplifier (38) and the voltage-to-frequency converter (47), and is operable through the switch (76) in another time period $(t_3)$ to receive timing pulses from the timing circuit (48 to 51) which count the counter (85) to zero while master clock pulses are received by the totaliser counter (72) to subtract from the counter (72) a number representative of the zero errors of the second operational amplifier (38) and the converter (47).

10.     A system as claimed in Claim 8 or Claim 9, including a display (104) connected to the totaliser counter (72) to display an indication of energy consumption accumulated by the totaliser counter (72).

11.    A system as claimed in Claim 6 or Claim 7, in a domestic power consumption meter wherein the display (104) gives a direct accumulative visual read-out of energy consumption.

Fig.1.

1/7

Fig.2.

Fig.3.

Fig.4.

Fig.5.

V_L

DISPLAY — PERIPHERAL INTERFACE — MICROPROCESSOR

BIPOLAR CONVERTER

I_L

Reference numerals: 1, 2, 3, 4, 5, 6, 7, 8, 9, 10, 12, 13, 14, 15, 16, 17, 18, 19, 20, 21, 22, 23, 24, 25, 26, 27, 28, 29, 30, 31, 32, 33, 34, 35, 36, 37, 45, 104, 117, 118, 119

*Fig.6.*

Fig.7.

European Patent
Office

**EUROPEAN SEARCH REPORT**

| DOCUMENTS CONSIDERED TO BE RELEVANT | | | EP 85303479.1 |
|---|---|---|---|
| Category | Citation of document with indication, where appropriate, of relevant passages | Relevant to claim | CLASSIFICATION OF THE APPLICATION (Int. Cl.4) |
| A | CH - A - 478 434 (REHM)<br>* Claims *<br>———— | 1 | G 01 R 21/08<br>G 01 R 22/00<br><br><br>TECHNICAL FIELDS<br>SEARCHED (Int. Cl.4)<br><br>G 01 R 21/00<br>G 01 R 22/00 |

The present search report has been drawn up for all claims

| Place of search<br>VIENNA | Date of completion of the search<br>21-08-1985 | Examiner<br>KUNZE |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82